Europäisches Patentamt

European Patent Office

Office européen des brevets

(11) Veröffentlichungsnummer: **0 268 159**
**A2**

(12) # EUROPÄISCHE PATENTANMELDUNG

(21) Anmeldenummer: **87116350.7**

(22) Anmeldetag: **05.11.87**

(51) Int. Cl.⁴: **H03K 5/08 , H03F 3/30**

(30) Priorität: **13.11.86 DE 3638708**

(43) Veröffentlichungstag der Anmeldung:
**25.05.88 Patentblatt 88/21**

(84) Benannte Vertragsstaaten:
**AT BE CH DE FR GB IT LI**

(71) Anmelder: **Siemens Aktiengesellschaft Berlin und München**
**Wittelsbacherplatz 2**
**D-8000 München 2(DE)**

(72) Erfinder: **Bayati, Abutorab, Dr.-Ing.**
**Schlehenweg 26**
**D-7500 Karlsruhe 31(DE)**

(54) **Halbleiterverstärkerschaltung.**

(57) Die Erfindung bezieht sich auf eine Halbleiterverstärkerschaltung mit mindestens einer Verstärkerstufe aus vier Transistoren (T1, T2, T3, T4), von denen jeweils zwei im Gegentaktbetrieb arbeiten, bei der das Verstärkungsverhalten, insbesondere für normierte Signale, verbessert ist. Zu diesem Zweck ist das eingangsseitig erste Transistorpaar (T1, T2), an deren zusammengeschalteten Basen das Eingangssignal (UE) anliegt, als Impedanzwandler betrieben, und die jedem Transistor (T1, T2) nachgeschalteten weiteren Transistoren arbeiten jeweils als Stromquelle, die untereinander im Gegentaktbetrieb arbeiten. Es ist ein gegenpolig parallel geschaltetes Diodenpaar (D3, D4) vorhanden, das über einen Kondensator (C5) vom Ausgang der Verstärkerstufe nach Masse geführt ist.

Die Erfindung ist vor allem bei Verstärkern für Anschlüsse an Busleitungen in der Datenübertragung anwendbar.

EP 0 268 159 A2

FIG 1

## Halbleiterverstärkerschaltung

Die Erfindung betrifft eine Halbleiterverstärkerschaltung gemäß dem Oberbegriff des Anspruchs 1.

Bei Busleitungen in der Datenübertragung, die einige Kilometer lang sein können und mehrere Teilnehmer untereinander verbinden, können zwischen Sender und Empfänger verschiedene Entfernungen entstehen. Deshalb müssen die Empfänger Signale mit großer Amplitudendynamik (bis zu 80 dB und mehr) verarbeiten können. Bei den frequenzmodulierten Signalen werden normierte Signale (TTL oder ECL) erzeugt, bei denen die Nulldurchgänge innerhalb der gesamten Dynamik denen der Eingangssignale entsprechen.

Der Erfindung liegt die Aufgabe zugrunde, das Verstärkungsverhalten der Transistorstufen, insbesondere für normierte Signale (TTL oder ECL), zu verbessern.

Zur Lösung dieser Aufgabe weist die erfindungsgemäße Halbleiterverstärkerschaltung die im Anspruch 1 angegebenen Merkmale auf und ermöglicht weiterhin die in den Unteransprüchen 2 und 3 beschriebenen vorteilhaften Ausführungsformen sowie die vorteilhafte Anwendung der Erfindung gemäß Anspruch 4.

Eine Verstärkerstufe gemäß der Erfindung besteht aus vier Transistoren, die, bezogen auf den Nullpunkt (Masse), wegen der Phasenverzerrung vollkommen symmetrisch arbeiten. Während die ersten beiden Transistoren als Impedanzwandler funktionieren, bilden die nächsten zwei Transistoren zwei Stromquellen, die im Gegentakt arbeiten. Durch die beiden Dioden, die gegenpolig parallel geschaltet sind, wird erreicht, daß der Verstärker nicht in Sättigung geht und damit die Amplitude seines Ausgangssignals begrenzt bleibt. Beim Einsatz von Si-Dioden wird z. B. eine Begrenzung von ± 0,7 V erreicht. Je nach Anwendung besteht die erfindungsgemäße Halbleiterverstärkerschaltung aus einer oder mehreren Verstärkerstufen. Die Verstärkerstufen sind außer der Endstufe einander identisch und werden hintereinandergeschaltet. Die Endstufe ist meistens ein TTL-oder ein ECL-Komparator.

Nach der Erfindung können Empfangsverstärker gebaut werden, die in einem Frequenzbereich bis zu 100 MHz eingesetzt werden können und je nach Frequenzbereich pro Stufe eine Verstärkung bis zu 30 dB erreichen. Durch die ersten beiden Transistoren kann der Empfangsverstärker praktisch an jede Signalquelle impedanzmäßig angepaßt werden. Da solche Empfangsverstärker unabhängig von Stufenanzahl nicht in Sättigung betrieben werden können, bleiben die Signalnulldurchgänge daher unverfälscht erhalten.

Die Erfindung wird anhand der Figuren erläutert, wobei

Figur 1 ein Ausführungsbeispiel einer mehrstufigen Halbleiterverstärkerschaltung und

Figur 2 ein Spannungsdiagramm bezüglich des Sättigungsverhaltens des Ausführungsbeispiels zeigt.

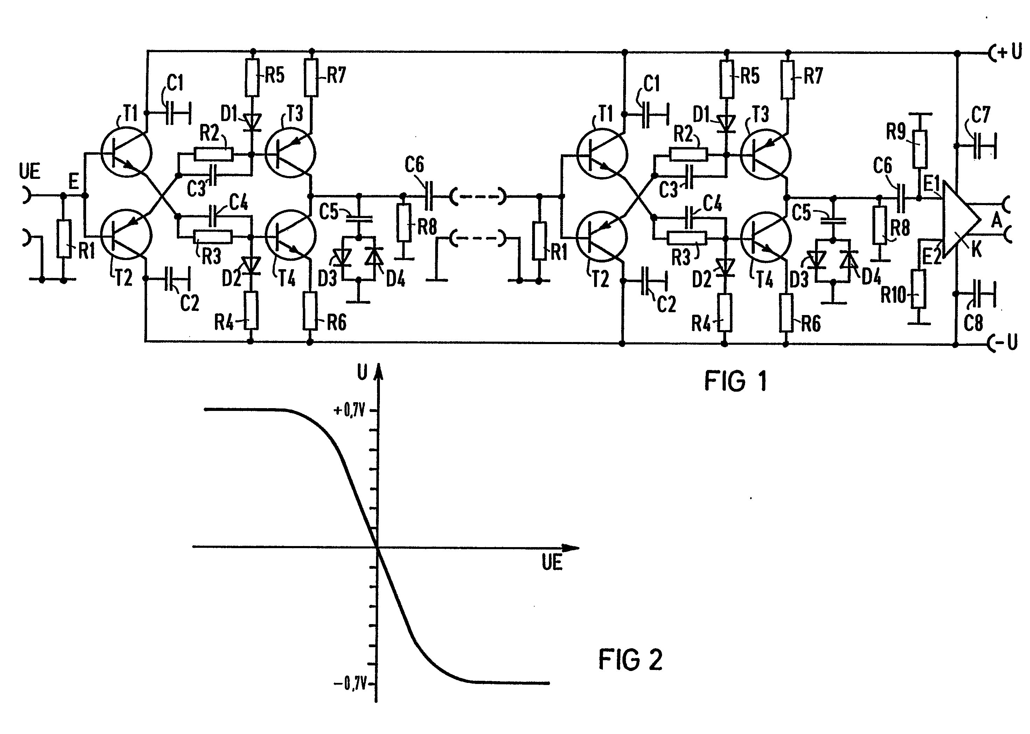

Am Eingang des Ausführungsbeispiels der Halbleiterverstärkerschaltung gemäß Figur 1 liegt die Eingangsspannung UE über einen Eingangswiderstand R1 an Masse an. Die Basen von Eingangstransistoren T1 und T2 sind zusammen an den Eingang geschaltet, wobei es sich beim Eingangstransistor T1 um einen npn-Transistor und beim Eingangstransistor T2 um einen pnp-Transistor handelt. Der Kollektor des Transistors T1 liegt an der positiven Versorgungsspannung +U, und der Kollektor des Eingangstransistors T2 liegt an der negativen Versorgungsspannung -U an. Weiterhin sind die Kollektoren der Transistoren T1 und T2 über Kondensatoren C1 und C2 nach Masse gelegt. Der Emitter des Transistors T1 ist über eine RC-Parallelschaltung R3, C4 an die Basis des nachgeschalteten Transistors T4 (npn) geführt. Hier liegt von der Basis der Reihenschaltung aus eine Diode D2 und R4 in Durchlaßrichtung zur negativen Versorgungsspannung -U. Die gleiche Verbindung ist zwischen dem Eingangstransistor T2 und T3 (pnp) hergestellt, hier liegt die Reihenschaltung aus einer Diode D1 und R5 jedoch an der positiven Versorgungsspannung +U. Der Emitter des Transistors T4 liegt über einen Widerstand R6 an der negativen Versorgungsspannung, und der Emitter des Transistors T3 liegt über einen Widerstand R7 an der positiven Versorgungsspannung. Die Kollektoren der Transistoren T3 und T4 sind zusammengeschaltet und bilden den Ausgang dieser Verstärkerstufe.

An diesen Ausgang ist über einen Kondensator C5 eine Parallelschaltung aus gegenpoligen Dioden D3 und D4 geschaltet, die mit dem anderen Schaltungspunkt an Masse liegt. Mit der Anschaltung dieser Dioden D3 und D4 kann beispielsweise eine Begrenzung der Spannung bei Si-Dioden von ± 0,7 V erreicht werden, so daß der Verstärker nicht in die Sättigung geht und damit die Amplitude des Ausgangssignals begrenzt bleibt. Das Ausgangssignal dieser Verstärkerstufe wird über einen Kondensator C6 und einen nach Masse geschalteten Widerstand R8 abgegriffen und kann einer Vielzahl von gleich aufgebauten Verstärkerstufen zugeleitet werden.

In der Figur 1 ist noch eine weitere, ebenfalls gleich aufgebaute Verstärkerstufe dargestellt, wie - schon vorher beschrieben. An den Ausgang dieser Verstärkerstufe ist jedoch ein Komparator K geschaltet, der ebenfalls an den Versorgungsspannungen +U und -U liegt und an seinem ersten Eingang E1 einen nach Masse geschalteten Widerstand R9 und an seinem zweiten Eingang E2 einen nach Masse geschalteten Widerstand R10 aufweist. Die Versorgungsspannungseingänge sind mit nach Masse geschalteten Kondensatoren C7 und C8 belegt. Am Ausgang A des Komparators K, der auch den Ausgang der gesamten Verstärkeranordnung darstellt, sind Signalleitungen für ein TTL-oder ECL-normiertes Signal vorhanden, die beispielsweise einer Teilnehmerstation an einer Busleitung zur Verfügung gestellt werden.

In der Figur 2 ist ein Spannungsdiagramm dargestellt, wie es am Ausgang einer jeden Verstärkerstufe entsteht. Diese Kennlinie mit der Begrenzung der Ausgangsspannung, mit der verhindert wird, daß der Verstärker nicht in die Sättigung geht, wird durch die gegenpolig parallel geschalteten Dioden D3 und D4 erreicht, die hier eine Spannungsbegrenzung bei ± 0,7 V für Si-Dioden hervorrufen.

**Ansprüche**

1. Halbleiterverstärkerschaltung mit
-mindestens einer Verstärkerstufe aus vier Transistoren (T1, T2, T3, T4), von denen jeweils zwei im Gegentaktbetrieb arbeiten,
**dadurch gekennzeichnet, daß**
-das eingangsseitig erste Transistorpaar (T1, T2), an deren zusammengeschalteten Basen das Eingangssignal (UE) anliegt, als Impedanzwandler betrieben wird und die jedem Transistor (T1, T2) nachgeschalteten weiteren Transistoren jeweils als Stromquelle arbeiten, die untereinander im Gegentaktbetrieb arbeiten, und daß
-ein gegenpolig parallel geschaltetes Diodenpaar (D3, D4) vorhanden ist, das über einen Kondensator (C5) vom Ausgang der Verstärkerstufe nach Masse geführt ist.

2. Halbleiterverstärkerschaltung nach Anspruch 1, **dadurch gekennzeichnet, daß**
-eine positive und negative Versorgungsspannung (+U, -U) vorhanden ist, an der jeweils ein Kollektor des eingangsseitigen Transistorpaars (T1, T2) und jeweils ein Emitter der nachgeschalteten Transistoren (T3, T4) über Widerstände (R7, R6) angeschaltet ist, und
-eine Verbindung zwischen dem Emitter des jeweiligen Eingangstransistors (T1; T2) und der Basis des nachgeschalteten, gleich aufgebauten (pnp bzw. npn) Transistors (T3; T4) über ein Parallel-RC-Glied (R2, C3; R3, C4) geschaltet ist, wobei
-von jeder Basis der nachgeschalteten Transistoren (T3, T4) eine Reihenschaltung einer Diode (D1; D2) und einem Widerstand (R5; R4) zu einer der Versorgungsspannungen (+U, -U) in Durchlaßrichtung geführt ist.

3. Halbleiterverstärkerschaltung nach Anspruch 1 oder 2, **dadurch gekennzeichnet, daß**
-eine Anzahl der Verstärkerstufen in Reihe geschaltet und der Ausgang der letzten Verstärkerstufe auf einen Komparator (K) geschaltet ist, an dessen Ausgang ein TTL-und/oder ECL-Signal anliegt.

4. Anwendung der Halbleiterverstärkerschaltung nach einem der vorhergehenden Ansprüche, **gekennzeichnet durch**
-Empfangsverstärker an Busleitungen für Datenübertragungsanlagen.

86 P 4448

FIG 1

FIG 2